# EUROPÄISCHE PATENTSCHRIFT

(11) **EP 2 178 789 B1**
(45) Veröffentlichungstag und Bekanntmachung des Hinweises auf die Patenterteilung: **29.08.2018**
(21) Anmeldenummer: 08761045.7
(22) Anmeldetag: 16.06.2008
(51) Int. Cl.: B81B 3/00

(54) **MIKROMECHANISCHES BAUELEMENT UND VERFAHREN ZUM BETRIEB EINES MIKROMECHANISCHEN BAUELEMENTS**
MICROMECHANICAL COMPONENT AND METHOD FOR OPERATING A MICROMECHANICAL COMPONENT
COMPOSANT MICRO-MÉCANIQUE ET PROCÉDÉ POUR LE FAIRE FONCTIONNER

(30) Priorität: 16.07.2007 DE 102007033002
(43) Veröffentlichungstag der Anmeldung: 28.04.2010
(73) Patentinhaber: Robert Bosch GmbH, 70442 Stuttgart (DE)
(72) Erfinder: BAUER, Wolfram, 72074 Tuebingen (DE); CLASSEN, Johannes, 72764 Reutlingen (DE)
(86) Internationale Anmeldenummer: PCT/EP2008/057528
(87) Internationale Veröffentlichungsnummer: WO 2009/010354

(56) Entgegenhaltungen:
- US-A- 5 554 304
- US-A- 6 133 670
- US-A1- 2003 029 705
- US-B1- 6 307 298
- WENJING YE ET AL: "Optimal Shape Design of an Electrostatic Comb Drive in Microelectromechanical Systems" JOURNAL OF MICROELECTROMECHANICAL SYSTEMS, IEEE SERVICE CENTER, PISCATAWAY, NJ, US, Bd. 7, Nr. 1, 1. März 1998 (1998-03-01), XP011034786 ISSN: 1057-7157
- ROSA M A ET AL: "Enhanced electrostatic force generation capability of angled comb finger design used in electrostatic comb-drive actuators" ELECTRONICS LETTERS, IEE STEVENAGE, GB, Bd. 34, Nr. 18, 3. September 1998 (1998-09-03), Seiten 1787-1788, XP006010262 ISSN: 0013-5194

## Beschreibung

### Stand der Technik

Die Erfindung geht aus von einem mikromechanischen Bauelement nach dem Oberbegriff des Anspruchs 1.

Solche mikromechanischen Bauelemente sind allgemein bekannt. Beispielsweise ist aus der Druckschrift US 5 025 346 ein mikromechanisches Bauelement bekannt, welches ein Trägersubstrat und eine seismische Masse aufweist, wobei das Trägersubstrat zweite Elektroden und die seismische Masse erste Elektroden umfasst und wobei die seismische Masse in einer Hauptbewegungsrichtung gegenüber dem Trägersubstrat beweglich ist. Die zweite Elektroden als auch die erste Elektroden überlappen sich in einer zur Hauptbewegungsrichtung senkrechten Richtung in einer Haupterstreckungsebene des Trägersubstrats. Eine Bewegung der seismischen Masse bewirkt eine Veränderung der Überlappungsfläche, während der durchschnittliche Abstand entlang des Überlappungsbereichs zwischen erste Elektroden und zweite Elektroden stets konstant bleibt. Die Eigenfrequenz der seismischen Masse wird durch die Masse der seismischen Masse, die Form der seismischen Masse und durch Aufhängungselemente der seismischen Masse festgelegt und ist nach Abschluss des Herstellungsprozess nicht modifizierbar. Weitere Ausführungsformen solcher mikromechanischen Bauelemente sind in den Patentschriften US-A-5554304, US-A-6133670, US-A-6307298 und den wissenschaftlichen Veröffentlichungen "Enhanced electrostatic force generation capability of angled comb finger design used in electrostatic comb-drive actuators" (Electronics Letters Vol. 34 No. 18 pp. 1787-1788, XP006010262) und "Optimal Shape Design of an Electrostatic Comb Drive in Microelectromechanical Systems" (Journal of Microelectromechanical Systems, Vol. 7, No. 1 pp. 16-26, XP011034786) beschrieben. Die Druckschrift US-A-2003/0029705 enthält die Beschreibung einer bistabilen Struktur, die wiederum durch eine Anordnung zweier Elektroden angetrieben wird.

### Offenbarung der Erfindung

Das erfindungsgemäße mikromechanische Bauelement und das Verfahren zum Betrieb eines mikromechanischen Bauelements gemäß den nebengeordneten Ansprüchen haben gegenüber dem Stand der Technik den Vorteil, dass eine effektive Federsteifigkeit und ein Schwingungsverhalten der ersten Elektroden und/oder zweiten Elektroden durch Anlegen einer konstanten elektrischen Potentialdifferenz zwischen den zweiten Elektroden und den ersten Elektroden modifizierbar ist. Bevorzugt werden daher Temperaturabhängigkeiten im Schwingungsverhalten der ersten und/oder zweiten Elektroden kompensiert, so dass eine Funktion des mikromechanischen Bauelements als Taktgeber ermöglicht wird. Die Änderung des durchschnittlichen Abstandes im Überlappungsbereich zwischen der ersten Elektroden und der zweiten Elektroden durch die Bewegung der ersten Elektroden entlang der Hauptbewegungsrichtung, d.h. welche im Wesentlichen auch parallel zur Haupterstreckung der ersten und zweiten Elektroden verläuft, bewirkt einen zusätzlichen Mitkopplungsterm in einem analytischem Ausdruck zur Berechnung der effektiven Federsteifigkeit. Die effektive Federsteifigkeit ergibt sich daher aus der Summe der Federsteifigkeit mit einem zusätzlichen Summanden, welcher im Wesentlichen eine quadratische Abhängigkeit von einer Potentialdifferenz zwischen der ersten Elektrode und der zweiten Elektrode aufweist. Folglich ist die effektive Federsteifigkeit und daher auch das Schwingungsverhalten, d.h. insbesondere auch die Eigenfrequenz, der ersten Elektroden gegenüber den zweiten Elektroden, bevorzugt durch Anlegen einer konstanten Potentialdifferenz als Mitkopplungsspannung, modifizierbar. Insbesondere lässt sich durch eine geeignete Nachführung der Mitkopplungsspannung eine im Vergleich zum Stand der Technik deutlich höhere Temperaturstabilität der Schwingung erreichen, wodurch insbesondere die Verwendung des mikromechanischen Bauelements als präziser Taktgeber ermöglicht wird. Bevorzugt als Taktgeber in einem Kommunikationsgerät, insbesondere zur CAN-Kommunikation im Automobilbereich.

Durch die in den Unteransprüchen aufgeführten Maßnahmen sind vorteilhafte Weiterbildungen und Verbesserungen des im Hauptanspruch angegebenen mikromechanischen Bauelements möglich.

Gemäß einer bevorzugten Ausführungsform des erfindungsgemäßen mikromechanischen Bauelements ist vorgesehen, dass die erste und/oder die zweite Elektrode einteilig mit einer seismischen Masse und/oder einer Feststruktur verbunden ist. Vorteilhaft sind somit mikromechanische Bauelemente mit ersten und zweiten Elektroden jeweils an einer ersten und zweiten seismischen Masse, welche sich relativ zueinander bewegen, oder mikromechanische Bauelemente mit ersten und zweiten Elektroden, welche jeweils mit einer seismischen Masse und einer Feststruktur verbunden sind, realisierbar. Im Folgenden wird daher die zweite Elektrode als Festelektrode einer Feststruktur und die erste Elektrode als Gegenelektrode einer seismischen Masse bezeichnet.

Gemäß einer bevorzugten Ausführungsform des erfindungsgemäßen mikromechanischen Bauelements ist vorgesehen, dass eine Bewegung der seismischen Masse parallel zur Hauptbewegungsrichtung eine Größenänderung des Überlappungsbereichs der Gegenelektrode mit der Festelektrode bewirkt. Vorteilhaft wird somit ein mitgekoppelter Kammantrieb ermöglicht, welcher eine Bewegungsanregung der seismischen Masse gegenüber der Feststruktur durch Anlegen geeigneter elektrischer Antriebspotentialdifferenzen zwischen den Gegen- und Festelektroden bewirkt. Die Überlagerung der Antriebspotentialdifferenz mit der Mitkopplungsspannung ermöglicht zusätzlich zur Schwingungsanregung die gleichzeitige Modifizierung der effektiven Federsteifigkeit.

Gemäß einer weiteren bevorzugten Ausführungsform des erfindungsgemäßen mikromechanischen Bauelements ist vorgesehen, dass in einer Ruhelage der seismischen Masse die Projektion der Gegenelektrode mit der Projektion der Festelektrode jeweils senkrecht zur Hauptbewegungsrichtung und in der Haupterstreckungsebene überlappend und/oder überlappungsfrei vorgesehen ist. Vorteilhaft bewirkt ein Ruheüberlapp eine effizientere Schwingungsanregung der seismischen Masse aus der Ruhelage, da bereits in der Ruhelage die Überlappung zur Ausbildung einer größeren Kapazität zwischen Gegen- und Festelektrode gegenüber einer überlappungsfreien Ruhelage führt. Ein mikromechanisches Bauelement, wobei die Gegen- und zweite Elektroden in der Ruhelage überlappungsfrei sind und lediglich in einer Auslenkungslage eine Überlappung aufweisen, vereinfacht den Herstellungsprozess der Elektrodenanordnung erheblich, da technologisch bedingte Minimalabstände bei der Strukturherstellung keinen Einfluss auf die Abstände der im Herstellungsprozess beabstandeten Gegen- und Festelektroden haben.

Erfindungsgemäß ist vorgesehen, dass die Projektion senkrecht zur Haupterstreckungsebene der Gegenelektrode und/oder der Festelektrode oval oder parabelförmig ausgebildet ist, wobei insbesondere die Festelektrode im Wesentlichen als eine Negativform der entsprechenden Gegenelektrode ausgebildet ist. Es ist ebenfalls eine Anordnung der Gegen- und Festelektrode vorgesehen, wobei die Projektion der Gegenelektrode im Wesentlichen als eine Negativform der Projektion der entsprechenden Festelektrode ausgebildet ist. Vorteilhaft wird durch die entsprechenden Elektrodenformen in einfacher Weise die Änderung des mittleren Abstands zwischen der Gegen- und Festelektrode im Überlappungsbereich bei einer Bewegung der seismischen Masse entlang der Hauptbewegungsrichtung bewirkt. Insbesondere ermöglichen die verschiedenen Elektrodenformen und/oder Variationen in der Elektrodenformdimensionierung die Anpassung des durch die Mitkopplungsspannung einstellbaren Modifikationsbereiches an die geforderten Schwingungseigenschaften.

Gemäß einer weiteren bevorzugten Ausführungsform des erfindungsgemäßen mikromechanischen Bauelements ist vorgesehen, dass die Gegenelektrode und die Festelektrode derart ausgeführt vorgesehen sind, dass das Schwingungsverhalten und die effektive Federsteifigkeit der seismischen Masse abhängig von einer konstanten Potentialdifferenz zwischen der Gegenelektrode und der Festelektrode ist. Vorteilhaft ist das Schwingungsverhalten und die effektive Federsteifigkeit daher mittels Anlegen einer Mitkopplungsspannung modifizierbar, insbesondere während des laufenden Schwingungsbetriebes der seismischen Masse. Die Änderung des Schwingungsverhaltens und der effektiven Federsteifigkeit ermöglicht besonders vorteilhaft eine dynamische Nachführung der effektiven Federsteifigkeit, welche bevorzugt durch eine integrierte, elektrische Schaltung erfolgt und besonders bevorzugt eine stetige Kompensation der Temperaturabhängigkeit der Schwingung bewirkt.

Gemäß einer weiteren bevorzugten Ausführungsform des erfindungsgemäßen mikromechanischen Bauelements ist vorgesehen, dass die Gegenelektrode und die Festelektrode derart ausgeführt vorgesehen sind, dass das mikromechanische Bauelement einen Antriebs- bzw. Antriebsdetektionskamm, insbesondere für einen Drehratensensor, umfasst. Vorteilhaft wird somit eine Temperaturstabilisierung eines Drehratensensors ermöglicht, wodurch der Drehratensensor als präziser Taktgeber einsetzbar ist, insbesondere für Kommunikationsgeräte, welche eine genaue Taktung von Übertragungszyklen erfordern und/oder über CAN- Schnittstellen kommunizieren.

Ein weiterer Gegenstand der vorliegenden Erfindung ist ein Verfahren zum Betrieb eines mikromechanischen Bauelements, wobei eine Bewegung der seismischen Masse gegenüber der Feststruktur parallel zur Hauptbewegungsrichtung mittels elektrostatischer Kräfte zwischen der Gegenelektrode und der Festelektrode angeregt wird. Vorteilhaft wird somit die Schwingung der seismischen Masse gegenüber der Feststruktur durch Anlegen der Antriebsspannungsdifferenz angeregt.

Erfindungsgemäß ist zum Betrieb eines mikromechanischen Bauelements vorgesehen, dass durch eine Bewegung der seismischen Masse gegenüber der Feststruktur parallel zur Hauptbewegungsrichtung eine Änderung des durchschnittlichen Abstandes im Überlappungsbereich der Projektion der Gegenelektrode mit der Projektion der Festelektrode jeweils senkrecht zur Hauptbewegungsrichtung und jeweils in der Haupterstreckungsebene erzeugt wird. Vorteilhaft entsteht daher ein zusätzlicher Mitkopplungsterm im analytischen Ausdruck für die effektive Federsteifigkeit, so dass eine Änderung des Schwingungsverhaltens und der effektiven Federsteifigkeit ermöglicht wird, welche insbesondere unabhängig von den Aufhängelementen der seismischen Masse ist und während des Schwingungsbetriebes modifizierbar ist. Besonders vorteilhaft bewirkt dies eine Verschiebung der Eigenfrequenz der seismischen Masse und/oder eine Temperaturkompensation der Schwingung.

Gemäß einer weiteren bevorzugten Ausführungsform zum Betrieb eines mikromechanischen Bauelements ist vorgesehen, dass eine Anpassung des Schwingungsverhaltens der seismischen Masse mittels weiterer elektrostatischer Kräfte zwischen der Gegenelektrode und der Festelektrode, welche insbesondere durch Anlegen einer geeigneten Potentialdifferenz zwischen der Gegenelektrode und der Festelektrode bewirkt werden, durchgeführt wird. Vorteilhaft wird somit eine Anpassung der effektiven Federsteifigkeit und des Schwingungsverhaltens der seismischen Masse durch die Mitkopplungsspannung ermöglicht. Eine Überlagerung von Mitkopplungsspannung und Antriebsspannungsdifferenz ermöglicht besonders vorteilhaft die Schwingungsanpassung und die dynamische Nachführung der Schwingungsanpassung während des Schwingvorgangs.

Ein weiterer Gegenstand der vorliegenden Erfindung ist eine Verwendung eines erfindungsgemäßen mikromechanischen Bauelements als taktgebendes Element, bevorzugt als temperaturstabilisiertes taktgebendes Element, besonders bevorzugt als Taktgeber für eine CAN-Frequenz im Automobilbereich.

Ausführungsbeispiele der Erfindung sind in der Zeichnung dargestellt und in der nachfolgenden Beschreibung näher erläutert.

### Kurze Beschreibung der Zeichnungen

Es zeigen
**Figur 1** eine schematische Aufsicht eines Bauelements gemäß einer ersten Ausführungsform des Standes der Technik, wobei eine seismische Masse des mikromechanischen Bauelements in einer Ruhelage dargestellt ist,
**Figur 2** eine weitere schematische Aufsicht eines Bauelements gemäß der ersten Ausführungsform des Standes der Technik, wobei die seismische Masse in einer Auslenkungslage dargestellt ist,
**Figur 3** eine schematische Aufsicht eines Bauelements gemäß einer zweiten Ausführungsform des Standes der Technik und
**Figur 4** eine schematische Aufsicht eines erfindungsgemäßen Bauelements.

### Ausführungsform(en) der Erfindung

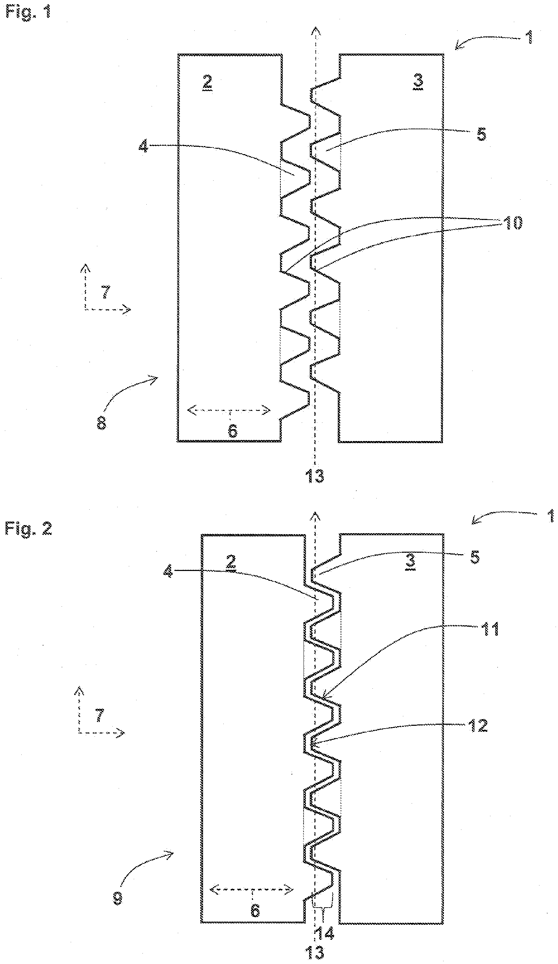

Die Bezugszeichen in den die verschiedenen Ausführungsformen des mikromechanischen Bauelements illustrierenden Figuren bezeichnen jeweils gleiche Elemente des erfindungsgemäßen Bauelements und werden daher nicht jeweils neu benannt. In **Figur 1** ist eine schematische Ausführungsform eines mikromechanischen Bauelements 1 gemäß einer beispielhaften ersten Ausführungsform des Standes der Technik dargestellt, wobei das mikromechanische Bauelement 1 eine Feststruktur 3 und eine seismische Masse 2 aufweist, wobei die Feststruktur 3 Festelektroden 5 bzw. zweite Elektroden 5 und die seismische Masse 2 Gegenelektroden 4 bzw. erste Elektroden aufweist und wobei die seismische Masse 2 gegenüber der Feststruktur 3 in einer Hauptbewegungsrichtung 6 beweglich ist. Die Darstellung zeigt das mikromechanische Bauelement 1 in einer Ruhelage 8, wobei die Projektion der Gegenelektrode 4 mit der Projektion der Festelektrode 5 jeweils senkrecht zur Hauptbewegungsrichtung 6 und in der Haupterstreckungsebene 7 überlappungsfrei sind. Die Gegenelektroden 4 und die Festelektroden 5 sind derart ausgebildet, dass eine Bewegung der seismischen Masse 2 parallel zur Hauptbewegungsrichtung 6 in Richtung der Feststruktur eine Änderung des durchschnittlichen Abstandes 11 im Überlappungsbereich 14 der Projektion der Gegenelektrode 4 mit der Projektion der Festelektrode 5 jeweils senkrecht zur Hauptbewegungsrichtung 6 und jeweils in einer Haupterstreckungsebene 7 bewirkt. Die Projektion wenigstens einer Gegen- und/oder Festelektrode 4, 5 senkrecht zur Haupterstreckungsebene 7 ist trapezförmig ausgebildet. Optional ist eine Ausbildung der Feststruktur 3 als eine weitere seismische Masse vorgesehen, wobei die Festelektrode 5 die bewegliche zweite Elektrode 5 umfasst.

In **Figur 2** ist eine schematische Aufsicht eines mikromechanischen Bauelements 1 gemäß der ersten Ausführungsform des Standes der Technik dargestellt, wobei sich die seismische Masse 2. jedoch nicht in der Ruhelage 8 gemäß der Darstellung in Figur 1, sondern in einer Auslenkungslage 9 befindet. Daher weisen die Gegenelektroden 4 den Überlappungsbereich 14 mit den Festelektroden 5 auf. Das Anlegen zweier geeigneter elektrischer Potentiale, d.h. einer Antriebsspannung, an die Gegenelektroden 4 und an Festelektroden 5 induziert eine anziehende elektrostatische Kraft zwischen den Gegen- und Festelektroden 4, 5, so dass eine resultierende Kraftwirkung zwischen der seismische Masse 2 und der Feststruktur 3 parallel zur Hauptbewegungsrichtung 6 erfolgt. Die Gegenelektroden 4 und die Festelektroden 5 sind dabei derart ausgebildet, dass eine Bewegung der seismischen Masse 2 parallel zur Hauptbewegungsrichtung 6 eine Änderung des durchschnittlichen Abstandes 11 zwischen der Gegenelektrode 4 und der Festelektrode 5 im Überlappungsbereich 14 bewirkt. Eine Überlagerung der Antriebsspannung mit einer Mitkopplungsspannung zwischen den Gegen- und Festelektroden 4, 5 führt daher zu einer Änderung der effektiven Federsteifigkeit und des Schwingungsverhaltens der seismischen Masse 2 bei einer Bewegung der seismischen Masse 2 gegenüber der Feststruktur 3 parallel zur Hauptbewegungsrichtung 6.

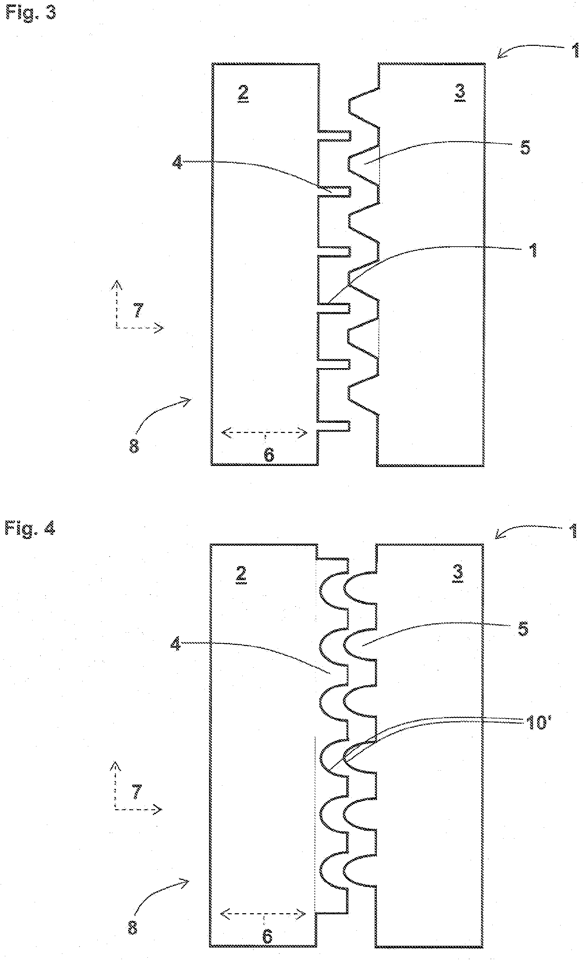

In **Figur 3** ist eine schematische Aufsicht eines mikromechanischen Bauelements gemäß einer zweiten Ausführungsform des Standes der Technik dargestellt, wobei die Abbildung im wesentlichen derjenigen der Figur 1 entspricht und lediglich die Projektion wenigstens einer Gegenelektrode 4 senkrecht zur Haupterstreckungsebene 7 eine Rechteckform aufweist, während die Projektion wenigstens einer Festelektrode trapezförmig ausgebildet ist. Bevorzugt ist eine Anordnung vorgesehen, wobei die Projektion der Gegenelektrode trapezförmig und die Projektion der Festelektrode rechteckig ausgebildet ist.

In **Figur 4** ist eine schematische Aufsicht eines erfindungsgemäßen mikromechanischen Bauelements dargestellt, wobei die Abbildung ebenfalls im wesentlichen derjenigen der Figur 1 entspricht und lediglich die Projektion wenigstens einer Festelektrode 5 senkrecht zur Haupterstreckungsebene 7 oval ausgebildet ist und/oder die Projektion wenigstens einer Gegenelektrode 4 eine Negativform der zweite Elektrodenform 5 aufweist. Alternativ ist eine Anordnung vorgesehen, wobei die Projektion der Gegenelektrode 4 oval ausgebildet ist und/oder eine Projektion der Festelektrode 5 eine Negativform der Gegenelektrode 4 aufweist.

## Patentansprüche

1. Mikromechanisches Bauelement (1) mit einer ersten Elektrode (4) und einer zweiten Elektrode (5), wobei die erste Elektrode (4) gegenüber der zweiten Elektrode (5) in einer Hauptbewegungsrichtung (6) beweglich ist, wobei die erste Elektrode (4) und die zweite Elektrode (5) derart ausgebildet vorgesehen sind, dass eine Bewegung der ersten Elektrode (4) parallel zur Hauptbewegungsrichtung (6) eine Änderung des durchschnittlichen Abstandes (11) zwischen erster Elektrode und zweiter Elektrode in einem Überlappungsbereich (14) der Projektion der ersten Elektrode (4) mit der Projektion der zweiten Elektrode (5) jeweils senkrecht zur Hauptbewegungsrichtung (6) und jeweils in einer Haupterstreckungsebene (7) bewirkt, **dadurch gekennzeichnet, dass** die Projektion senkrecht zur Haupterstreckungsebene (7) der ersten Elektrode (4) und/oder der zweiten Elektrode (5) oval oder parabelförmig ausgebildet ist, wobei insbesondere die zweite Elektrode (5) im Wesentlichen als eine Negativform der entsprechenden ersten Elektrode (4) ausgebildet ist.

2. Mikromechanisches Bauelement (1) nach Anspruch 1, **dadurch gekennzeichnet, dass** die erste Elektrode (4) und/oder die zweite Elektrode (5) derart ausgebildet ist, dass eine Bewegung der ersten Elektrode (4) und/oder der zweiten Elektrode parallel zur Hauptbewegungsrichtung (6) eine Größenänderung des Überlappungsbereichs (14) der ersten Elektrode (4) mit der zweiten Elektrode (5) bewirkt.

3. Mikromechanisches Bauelement (1) nach einem der vorhergehenden Ansprüche, **dadurch gekennzeichnet, dass** in einer Ruhelage (8) der ersten Elektrode (4) die Projektion der ersten Elektrode (4) mit der Projektion der zweiten Elektrode (5) jeweils senkrecht zur Hauptbewegungsrichtung (6) und in der Haupterstreckungsebene (7) überlappend oder überlappungsfrei vorgesehen ist.

4. Mikromechanisches Bauelement (1) nach einem der vorhergehenden Ansprüche, **dadurch gekennzeichnet, dass** die erste Elektrode (4) und die zweite Elektrode (5) derart ausgeführt vorgesehen sind, dass ein Schwingungsverhalten der ersten Elektrode (4), insbesondere die effektive Federsteifigkeit einer Aufhängung der ersten Elektrode (4), abhängig von einer konstanten Potentialdifferenz zwischen der ersten Elektrode (4) und der zweiten Elektrode (5) ist.

5. Mikromechanisches Bauelement (1) nach einem der vorhergehenden Ansprüche, **dadurch gekennzeichnet, dass** das mikromechanische Bauelement (1) einen Antriebs- bzw. Antriebsdetektionskamm, insbesondere für einen Drehratensensor, umfasst.

6. Mikromechanisches Bauelement (1) nach einem der vorhergehenden Ansprüche, **dadurch gekennzeichnet, dass** die erste und/oder zweite Elektrode einteilig mit einer seismischen Masse (2) und/oder einer Feststruktur (3) verbunden ist.

7. Verfahren zum Betrieb eines mikromechanischen Bauelements (1) nach einem der vorhergehenden Ansprüche, **dadurch gekennzeichnet, dass** eine Bewegung der ersten Elektrode (4) gegenüber der zweiten Elektrode (5) parallel zur Hauptbewegungsrichtung (6) mittels elektrostatischer Kräfte zwischen der ersten Elektrode (4) und der zweiten Elektrode (5) angeregt wird.

8. Verfahren zum Betrieb eines mikromechanischen Bauelements (1) nach Anspruch 7, **dadurch gekennzeichnet, dass** durch eine Bewegung der ersten Elektrode (4) gegenüber der zweiten Elektrode (5) parallel zur Hauptbewegungsrichtung (6) eine Änderung des durchschnittlichen Abstandes (11) im Überlappungsbereich (14) der Projektion der ersten Elektrode (4) mit der Projektion der zweiten Elektrode (5) jeweils senkrecht zur Hauptbewegungsrichtung (6) und jeweils in der Haupterstreckungsebene (7) erzeugt wird.

9. Verfahren zum Betrieb eines mikromechanischen Bauelements (1) nach einem der Ansprüche 7 oder 8, **dadurch gekennzeichnet, dass** eine Anpassung des Schwingungsverhaltens der seismischen Masse (2) mittels weiterer elektrostatischer Kräfte zwischen der ersten Elektrode (4) und der zweiten Elektrode (5), welche insbesondere durch Anlegen einer geeigneten Potentialdifferenz zwischen der ersten Elektrode (5) und der zweiten Elektrode (4) bewirkt werden, durchgeführt wird.

10. Verwendung eines Mikromechanisches Bauelement (1) nach einem der Ansprüche 1 bis 6 als taktgebendes Element, bevorzugt als temperaturstabilisiertes taktgebendes Element, besonders bevorzugt als Taktgeber für eine CAN-Frequenz im Automobilbereich.

## Claims

1. Micromechanical component (1) having a first electrode (4) and a second electrode (5) wherein the first electrode (4) can move with respect to the second electrode (5) in a main movement direction (6) wherein the first electrode (4) and the second electrode (5) are provided embodied in such a way that a movement of the first electrode (4) parallel to the main movement direction (6) brings about a change in the average distance (11) between the first electrode and the second electrode in an overlapping region (14) of the projection of the first electrode (4) with the projection of the second electrode (5), in each case perpendicularly with respect to the main movement direction (6) and in each case in a main extension plane (7), **characterized in that** the projection is embodied in an oval or parabolic form perpendicularly with respect to the main extension plane (7) of the first electrode (4) and/or of the second electrode (5), wherein, in particular, the second electrode (5) is embodied essentially as a negative form of the corresponding first electrode (4).

2. Micromechanical component (1) according to Claim 1, **characterized in that** the first electrode (4) and/or the second electrode (5) are embodied in such a way that a movement of the first electrode (4) and/or of the second electrode parallel to the main movement direction (6) brings about a change in size of the overlapping region (14) of the first electrode (4) with the second electrode (5) .

3. Micromechanical component (1) according to one of the preceding claims, **characterized in that** in a position of rest (8) of the first electrode (4) the projection of the first electrode (4) is provided overlapping or free of overlap with the projection of the second electrode (5), in each case perpendicularly with respect to the main movement direction (6) and in the main extension plane (7).

4. Micromechanical component (1) according to one of the preceding claims, **characterized in that** the first electrode (4) and the second electrode (5) are provided embodied in such a way that an oscillation behaviour of the first electrode (4), in particular the effective spring stiffness of a suspension of the first electrode (4), is dependent on a constant potential difference between the first electrode (4) and the second electrode (5) .

5. Micromechanical component (1) according to one of the preceding claims, **characterized in that** the micromechanical component (1) comprises a drive comb or drive detection comb, in particular for a rotational speed sensor.

6. Micromechanical component (1) according to one of the preceding claims, **characterized in that** the first and/or second electrode are/is connected in one part to a seismic mass (2) and/or a fixed structure (3).

7. Method for operating a micromechanical component (1) according to one of the preceding claims, **characterized in that** a movement of the first electrode (4) with respect to the second electrode (5) parallel to the main movement direction (6) is excited by means of electrostatic forces between the first electrode (4) and the second electrode (5) .

8. Method for operating a micromechanical component (1) according to Claim 7, **characterized in that**, by means of a movement of the first electrode (4) with respect to the second electrode (5) parallel to the main movement direction (6), a change in the average distance (11) is generated in the overlapping region (14) of the projection of the first electrode (4) with the projection of the second electrode (5) in each case perpendicularly with respect to the main movement direction (6) and in each case in the main extension plane (7).

9. Method for operating a micromechanical component (1) according to one of Claims 7 or 8, **characterized in that** adaptation of the oscillation behaviour of the seismic mass (2) is carried out by means of further electrostatic forces between the first electrode (4) and the second electrode (5), which are brought about, in particular by applying a suitable potential difference between the first electrode (5) and the second electrode (4).

10. Use of a micromechanical component (1) according to one of Claims 1 to 6 as a clock-generating element, preferably as a temperature-stabilized, clock-generating element, particularly preferably as a clock generator for a CAN frequency in the field of motor vehicles.

## Revendications

1. Composant micromécanique (1), comprenant une première électrode (4) et une deuxième électrode (5), la première électrode (4) pouvant être déplacée dans une direction de déplacement principale (6) par rapport à la deuxième électrode (5), la première électrode (4) et la deuxième électrode (5) étant configurées de telle sorte qu'un mouvement de la première électrode (4) parallèlement à la direction de déplacement principale (6) provoque une modification de l'écart moyen (11) entre la première électrode et la deuxième électrode dans une zone de chevauchement (14) de la projection de la première électrode (4) avec la projection de la deuxième électrode (5) respectivement perpendiculairement à la direction de déplacement principale (6) et respectivement dans un plan d'extension principal (7), **caractérisé en ce que** la projection perpendiculaire au plan d'extension principal (7) de la première électrode (4) et/ou de la deuxième électrode (5) est de forme ovale ou parabolique, la deuxième électrode (5) étant notamment configurée comme une forme négative de la première électrode (4) correspondante.

2. Composant micromécanique (1) selon la revendication 1, **caractérisé en ce que** la première électrode (4) et/ou la deuxième électrode (5) sont configurées de telle sorte qu'un mouvement de la première électrode (4) et/ou de la deuxième électrode parallèlement à la direction de déplacement principale (6) produit un changement de taille de la zone de chevauchement (14) de la première électrode (4) avec la deuxième électrode (5).

3. Composant micromécanique (1) selon l'une des revendications précédentes, **caractérisé en ce que** dans une position de repos (8) de la première électrode (4), la projection de la première électrode (4) est respectivement conçue en chevauchement ou sans chevauchement avec la projection de la deuxième électrode (5) perpendiculairement à la direction de déplacement principale (6) et dans le plan d'extension principal (7).

4. Composant micromécanique (1) selon l'une des revendications précédentes, **caractérisé en ce que** la première électrode (4) et la deuxième électrode (5) sont conçues exécutées de telle sorte qu'un comportement oscillant de la première électrode (4), notamment la raideur de ressort effective d'une suspension de la première électrode (4), est dépendant d'une différence de potentiel constante entre la première électrode (4) et la deuxième électrode (5).

5. Composant micromécanique (1) selon l'une des revendications précédentes, **caractérisé en ce que** le composant micromécanique (1) comporte une came d'entraînement ou de détection d'entraînement, notamment pour un capteur de vitesse de rotation.

6. Composant micromécanique (1) selon l'une des revendications précédentes, **caractérisé en ce que** la première et/ou la deuxième électrode sont reliées d'un seul tenant à une masse sismique (2) et/ou une structure fixe (3).

7. Procédé de fonctionnement d'un composant micromécanique (1) selon l'une des revendications précédentes, **caractérisé en ce qu'**un mouvement de la première électrode (4) par rapport à la deuxième électrode (5) parallèlement à la direction de déplacement principale (6) est excité au moyen des forces électrostatiques entre la première électrode (4) et la deuxième électrode (5).

8. Procédé de fonctionnement d'un composant micromécanique (1) selon la revendication 7, **caractérisé en ce qu'**une modification de l'écart moyen (11) dans la zone de chevauchement (14) de la projection de la première électrode (4) avec la projection de la deuxième électrode (5) respectivement perpendiculairement à la direction de déplacement principale (6) et respectivement dans le plan d'extension principal (7) est produite par un mouvement de la première électrode (4) par rapport à la deuxième électrode (5) parallèlement à la direction de déplacement principale (6).

9. Procédé de fonctionnement d'un composant micromécanique (1) selon l'une des revendications 7 ou 8, **caractérisé en ce qu'**une adaptation du comportement oscillant de la masse sismique (2) est effectuée au moyen de forces électrostatiques supplémentaires entre la première électrode (4) et la deuxième électrode (5), lesquelles sont notamment provoquées par l'application d'une différence de potentiel appropriée entre la première électrode (4) et la deuxième électrode (5).

10. Utilisation d'un composant micromécanique (1) selon l'une des revendications 1 à 6 en tant qu'élément transmetteur de cycle, en tant qu'un élément transmetteur de cycle stabilisé en température, notamment en tant que transmetteur de cycle pour une fréquence CAN dans le secteur automobile.
